# EUROPEAN PATENT APPLICATION

(11) **EP 1 431 833 A2**
(43) Date of publication of application: **23.06.2004**
(21) Application number: 03079077.8
(22) Date of filing: 15.12.2003
(51) Int. Cl.: G03F 9/00

(54) **Lithographic apparatus, device manufacturing method, and device manufactured thereby**

(30) Priority: 16.12.2002 EP 02080336
(71) Applicant: ASML Netherlands B.V., 5503 LA Veldhoven (NL)
(72) Inventor: Den Boef, Arie Jeffrey, 5581 AB Waalre (NL); Mos, Everhardus Cornelis, 5643 AX Eindhoven (NL); van der Schaar, Maurits, 5508 LA Veidhoven (NL)
(74) Representative: Prins, Adrianus Willem, Mr. Ir.

(57) **Abstract**

During device manufacturing a projection beam is projected onto a substrate through a mask. The substrate is aligned with the mask using an alignment structure on the substrate. Properties of the light reflected from the alignment structure are used to determine the relative position of the substrate. Preceding processing of the substrate potentially causes errors in the position determined from the reflected light. measurement of properties of the reflected light are used to determine the size of a correction that is needed to correct for the errors caused by processing of the substrate. Preferably parameters of a physical model of the alignment structure are estimated from the reflected light and used to determine the correction. Preferably, the amplitudes of a plurality of different diffraction peaks are measured to determine the correction.

## Description

The present invention relates to a lithographic projection apparatus and device manufacturing method as set forth in the preamble of the independent claims. The lithographic projection apparatus comprises:
- a radiation system for providing a projection beam of radiation;
- a support structure for supporting patterning means, the patterning means serving to pattern the projection beam according to a desired pattern;
- a substrate table for holding a substrate that comprises an alignment structure;
- a projection system for projecting the patterned beam onto a target portion of the substrate; and
- an alignment system.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Before the patterned beam can be projected onto substrate W, substrate W and the patterning means have to be positioned relative to one another so that the projected beam will strike the substrate at the required target position. For this purpose, it is desirable to provide the lithographic apparatus with the capability to provide a highly accurate measurement of the position of the substrate relative to the patterning means or the support structure for the patterning means.

A method of aligning a substrate in a lithographic apparatus is described in an article by A.A Ghazanfarian et al, titled "Exploiting structure in positioning of non-symmetric signals" and published in the proceedings of the ICCASP 1998. Ghazanfarian et al use a scanning/imaging technique. An alignment mark is provided on the substrate and light scattered from the alignment mark is detected when the mark is scanned. Details of the detection technique are not disclosed, but the result is a detected signal which has lineshape with a peak as a function of scanning position. The location of the peak nominally corresponds to the position of the alignment mark.

Ghazanfarian et al recognize the fact that accuracy of this type of measurement is affected by the optical system and the processing steps to which the substrate has been subjected. In particular, systematic alignment errors arise due to asymmetry in the optical system and processing steps that affect the symmetry of structures on the substrate. These errors may vary from batch to batch, due to the effect of variations in wafer processing conditions, from wafer to wafer or even between different positions on a wafer.

Ghazanfarian et al overcome these errors by introducing a modelling step. The modelled lineshape of the detected signal as a function of a number of "hidden" parameters is used. During normal alignment Ghazanfarian et al fit the values of the hidden parameters to best approximate the measured lineshape. The position of the alignment mark offset is determined by determining which offset must be applied to the modelled lineshape is needed to fit the modelled lineshape to the measured lineshape.

Prior to actual alignment the relation between the hidden parameters and the modelled lineshape is determined and the number of hidden parameters is selected. This involves a learning phase in which a number of samples of alignments marks are used, of which the position is measured in some reliable way and of which the lineshape of the detection signal is measured. The samples represent a spread of different lineshapes and offsets that are typical that may occur during normal alignment. Ghazanfarian et al use a singular value decomposition technique to generate a model capable of representing this spread and the corresponding position errors in terms of a minimum number of hidden parameters.

The technique used by Ghazanfarian et al has a number of drawbacks. First of all, during the model forming step accurate measurements of the actual position of the alignment marks are needed. Such measurements are difficult to realize and a considerable number of such measurements is needed during the model forming step. A different set of measurements has to be obtained for each lithographic step during manufacturing of the substrate. This makes the technique very expensive.

Secondly, the technique of Ghazanfarian et al requires a type of measurement that produces a lineshape that contains sufficient information as a function of scanning position to permit determination of sufficient hidden parameters to correct the position errors of the peak of the lineshape. This excludes correction of lineshapes that contain insufficient information.

A technique for realizing alignment uses a phase grating alignment measurement. In this case alignment marks with periodically varying optical properties are included on the substrate. Intensity of light scattered by the alignment mark is measured and the phase of observed periods of the alignment mark relative to some defined position in the lithographic apparatus is determined to measure the position of the alignment mark.

To eliminate errors a diffraction technique is used. The spatially periodic optical properties of the alignment mark lead to diffraction of light in different orders of diffraction much as by a diffraction grating. During the phase grating alignment measurement the alignment mark is lighted with monochromatic light and different orders of light are diffracted from the alignment mark. Light from pairs of orders is separated and used to for a detection signal, of which the intensity varies periodically as a function of displacement of the alignment mark, due to the periodic nature of the alignment mark. The intensity is used to generate a detection signal, from which the position of the alignment mark is determined (up to an integer number of periods of the alignment mark). A combination of position measurements from different pairs of orders of diffraction may be used to realize a more reliable position measurement.

This technique has also been found to suffer from misalignment errors due to asymmetry induced by substrate processing effects. Ghazanfarian et al do not describe correction of this type of measurement. However, when applied to the detection signal for a pair of orders of diffraction, insufficient information is generally available in this detection signal to fit a sufficient number of hidden parameters for correction of misalignment errors.

It is an object of the invention to provide for accurate correction of misalignment errors that occur when the substrate is aligned after being subjected to processing, without requiring extensive calibration measurements.

It is another object of the invention to provide for accurate correction of misalignment errors when using a phase grating alignment system.

The invention provides for a lithographic apparatus as set forth in Claim 1.

Light affected by the substrate contains both positional information, that is, information which is affected by displacement of the substrate, and position invariant information, which does not change under displacement, at least if uniform lighting is used. Examples of positional information are the phase of light diffracted by a grating, or the position of the image of a feature on the substrate. Examples of invariant information includes the maximum intensity of diffracted or reflected light as a function of position. Normally, only positional information is used for alignment. The claimed apparatus is based on the insight that the position invariant information of light that has been affected by a substrate is characteristic of variations that occur in a process step and can there for be used to identify the variations and the size of the resulting correction that has to be applied to positional information.

In particular a combination of amplitudes of respective ones of a plurality of different pairs of orders of light diffracted by the alignment mark can be used to correct a position measurement from any single one or more of the pairs of orders. Based only on optical theoretical considerations for arbitrary alignment structures there is little or no reason to expect that the phase corrections can be determined from the amplitudes, but it has been realized that any given process step can only lead to a predetermined range of variations of the optical properties of the alignment mark, each with its own combined effect upon the amplitudes and the position measurement for different pairs. Thus, a correlation between amplitudes and position errors occurs that can be used to improve position measurement accuracy.

Because the intensities are used to determine the position corrections indirectly by identifying the type of deformation, the correction of position measurement for light of one wavelength need not be based on intensities measured with light of that wavelength, or only on intensities measured with light of that wavelength. Neither do the intensities need to be measured on the same alignment structure as the positions, or indeed on the same substrate: another substrate that has been subject to the same processing may be used to determine the required corrections as well. In an embodiment, amplitude measurements of the orders of diffraction of light of a number of different wavelengths may be used. Thus, the type of position corrections can be identified more accurately.

The phase measurement for different pairs of orders of diffraction may be used in addition to the intensities to determine the size of correction. In this case a separation between computation of a correction from the amplitudes and correction of the position measurement of from the phase is not strictly necessary. Where the claims speak of determining a correction "to be used" for determining the size of the correction of position this covers both explicit correction and correction that is determined implicitly during a determination of the position measurement from amplitudes and phases. In both cases position independent information affects the size of correction even if the position dependent phase information does not change.

In order to determine the corrections, use is preferably made of a model that characterizes physical properties of the alignment structure as a function of position in the alignment structure with a parametrized model. Parameters could for example be the duty cycle of the period of ridges in the alignment structure, the depth of the ridges, edge slope on either side of the ridges the height of unevenness of plateaus of the ridges and between ridges, position and amplitude of unevenness in a resist layer on top of the ridges etc. Preferably, such structure describing parameters are used to make the model accessible for persons that are not optical experts, but instead other types of parameters may be used, such as parametrized approximations of reflection coefficients of the substrate as a function of position.

By means of computations consistent with Maxwell's equations, one can predict for each combination of parameter values both the amplitudes for different orders of diffraction and the corrections of the determination of the position of the alignment structure. Preferably the corrections are determined by searching for the values of the parameters that lead to predicted intensities that best fit the measured amplitudes, followed by selection of the corrections that correspond to the selected parameters.

Such a model-based approach may also be applied to alignment systems that do not use periodic alignment structures and/or diffraction amplitudes to obtain position measurements. Any type of optical properties may be used to determine parameter values of parameters in a parametrized model of the alignment structure on the substrate, for use in correction position measurements. However, application to measurements using periodic alignment structures has the advantage that only a relatively limited number of parameters suffices to characterize the physical properties of the structure, while still describing an alignment structure with a relatively large area.

In another embodiment of the lithographic apparatus, the apparatus is arranged to compute a relation between one or more parameters of the model and a detection signal of the alignment system consistent with the physical laws of optics (expressed in mathematical terms, such as Maxwell's equations) for the alignment system, and to determine values of the one or more parameters so that the values correspond to the measured detection signal according to the relation, the position measurement being corrected dependent on the values. By implementing a relation between parameters of the substrate consistent with the physical laws of optics in the lithographic apparatus the need for extensive calibration of the relation for different lithographic process steps is avoided.

In a further embodiment of the lithographic apparatus, the apparatus provides a set of available parameters whose value can be used to determine the required correction and has an interface for selecting the one or more parameters from the available parameters, the apparatus being arranged to respond to selection of the subset by determining values of only the selected one or more shape parameters in correspondence to the measured detection signal. This enables the user of the lithographic apparatus to identify the type of errors for which corrections must be made after a processing step in terms of physical parameters for which no knowledge of the optical properties of the alignment system are needed. In addition, the user may specify values for the other shape parameters which are not expected to vary after a process step.

The selection of the combination of parameters that is used for this purpose is preferably made dependent on the process or processes to which the substrate is subjected prior to alignment, dependent on the nature of the range of variations caused by this process or these processes.

When a model is used that expresses the optical properties as a function of the parameters a search for the best parameter values may be performed in any known way. For example, a simulated annealing technique is used, because this technique overcomes local minima that have been found to occur in models that relate relevant parametrized optical properties of the alignment structure and the intensities of the orders of diffraction.

However, it is not necessary to determine the nature of the deformation of the alignment structure explicitly in terms of physical parameters, as long as the corrections of the phase measurements are determined. For example, a computation of a function may be used that assigns phase corrections to different combinations of intensities. Such a function may be defined specifically for a process step or process steps that have been performed prior to alignment. A parametrized function may be used for example, the value of the parameters being determined on theoretical grounds or by means of measurements for the process step or process steps. A simple example of such a function is a linear relation between intensity ratio's and phase corrections, the parameters being the coefficients of the linear relation. But of course other kinds of functions may be used, such as neural net functions that have been "trained" for the process step or process steps, or even a lookup table with entries for different combinations of intensities, the entries containing the corresponding phase corrections. Such functions, and especially neural net functions, have the advantage that little additional computation time is needed for individual substrates.

According to a further aspect of the invention there is provided a device manufacturing method according to Claim 13.

In a further embodiment the identification of the position correction is made in two or more stages, making use of the fact that the correction, or at least the parameters that determine the correction, are similar for structures that have been subjected to processing in common, for example in the same batch or on the same substrate. In this embodiment the parameters, or the correction, computed for an alignment structure is used as an initial value for a search for the parameters for a subsequent alignment mark. More generally, an estimated parameter or correction that has been estimated on average for a substrate or batch as a whole may be used to bias the estimate for individual alignment marks or groups of alignment marks. An embodiment includes a preselection stage in which a subset of available corrections is selected for a batch of a plurality of substrates (that have been subjected to process steps in common) from a first measurement of the intensities of the orders of diffraction and/or other parameters, and subsequent stage for selecting a specific correction for an individual alignment structure, or for an individual substrate or an individual region on such a substrate from a second measurement of the intensities of the orders of diffraction for that alignment mark or one or more alignment mark on said individual substrate or in said region. Similarly, instead or in addition to preselection at the batch level, preselection at the substrate level or region level may be used prior to final selection for an individual alignment structure or region on a substrate. Thus, less computation is needed to find the corrections for individual alignment marks and the consistency of the corrections is improved.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
Figure 1 depicts a lithographic projection apparatus according to an embodiment of the invention;
Figure 2 shows an alignment system
Figure 3 shows an example of a cross section of a height profile
Figure 4 shows a flow chart for aligning a substrate

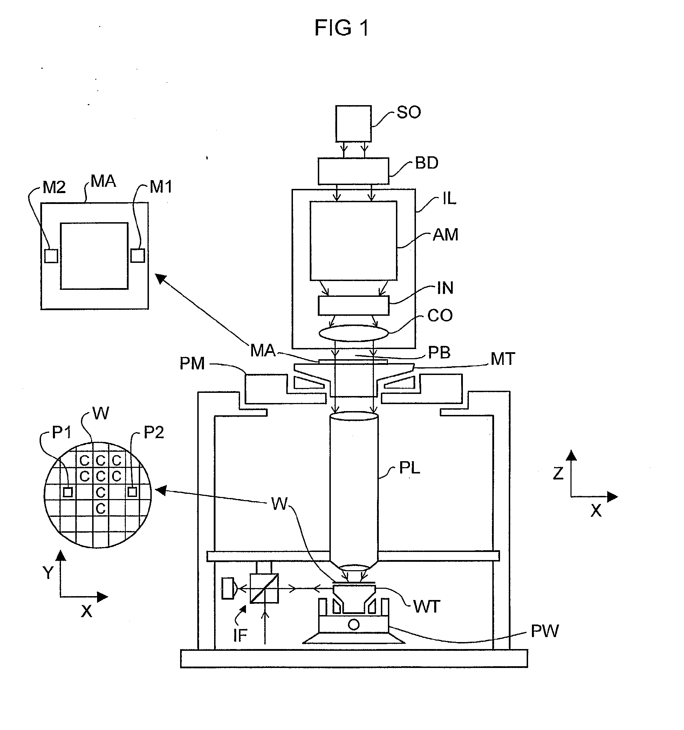

Figure 1 schematically depicts a lithographic projection apparatus 1 according to a particular embodiment of the invention. The apparatus comprises:
- a radiation system Ex, IL, for supplying a projection beam PB of radiation (e.g. laser radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. a laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

An alignment subsystem (not shown in figure 1) is included in the apparatus for accurately measuring the position of substrate W to ensure that substrate W is properly aligned during projection. The alignment subsystem may be needed for example because the location of substrate W on substrate table WT cannot be controlled with sufficient accuracy. Fluctuations in the processing steps may affect the phase shift of different substrates differently. In a semiconductor manufacturing process for example substrate W (a wafer) is subjected to many processing steps and in between groups of processing steps the wafer placed on substrate table and illuminated through a mask to ensure location dependent processing. Prior to illumination the mask and the substrate have to be aligned in order to ensure that the location where the mask is projected onto the wafer corresponds with the positions at which earlier masks have been projected and/or later masks will be projected.

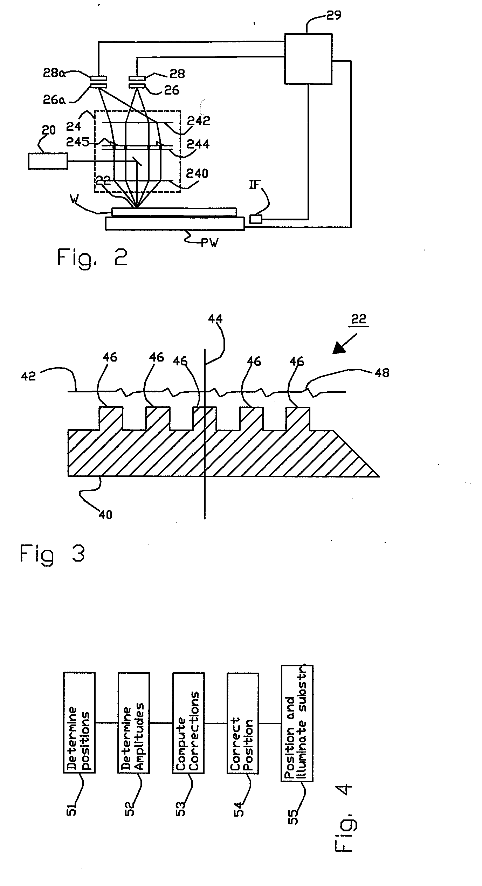

Figure 2 schematically shows an embodiment of the alignment subsystem, containing an optical subsystem with a radiation source 20, an imaging structure 24, reference structures 26, 26a, detectors 28, 28a and a processing unit 29. Although processing unit 29 is shown as one element, it will be understood that processing unit 29 may be made up of a number of interconnected processors.

Radiation source 20, for example a laser, is arranged to generate a spot of light on an alignment mark 22 on substrate W. For accurate alignment substrate W contains an alignment structure with spatially periodic reflection properties in alignment mark 22. Imaging structure 24 contains a lens arrangement 240, 242 to image alignment mark 22 onto reference structure 26. Reference structure 26 has spatially periodic transmissive properties. Detector 28 is arranged to detect a spatially averaged intensity of radiation transmitted by reference structure 26. Detector 28 has an output coupled to an input of processing unit 29, which in turn has a control output coupled to second positioning means PW, which are coupled to substrate W. Interferometric measuring means IF have an output coupled to processing unit 29.

It will be understood that various changes may be made to the alignment subsystem without affecting its function. For example, mirrors may be added to be able to move elements of the alignment subsystem to more convenient locations. In one embodiment the alignment subsystem is immediately next to the projection lens, but it will be understood that the alignment subsystem may be further removed from the projection lens. It is not necessary that the substrate is in the path of the projection beam during alignment. In fact, another substrate, on a separate substrate table may even be in the path of the projection beam during alignment.

In operation radiation from radiation source 20 is reflected from alignment mark 22 and imaging structure 24 uses the reflected radiation to image alignment mark 22 onto reference structure 26. The imaged radiation is partially transmitted by reference structure 26 onto detector 28 which generates an electric signal that is indicative of the spatially averaged intensity of the transmitted radiation.

During alignment this alignment structure is imaged onto reference structure 26. The spatially averaged amount of light transmitted by reference structure 26 depends periodically on the relative phase of the image of the alignment structure and reference structure 26. Imaging structure 24 passes only selected pairs of orders of diffraction onto reference structure 26. As shown, imaging structure 24 has been designed to filter out selected orders of diffraction from alignment mark 22. For this purpose imaging element contains lenses 240, 242 with a diffraction order filter 244 in between. A first lens 240 maps light diffracted in respective directions to respective positions on diffraction order filter 244, which transmits only light from selected positions. A second lens forms an image of alignment mark 22 from the transmitted light. Thus only selected pairs of orders of diffraction are used for imaging onto reference structure 26. Without such selective transmission position measurement is in principle also possible, but it has a worse signal to noise ratio.

As shown, a number of pairs of diffraction orders of the light from alignment mark 22 are treated separately. For separate treatment wedges 246 are provided to ensure that different pairs of orders are imaged onto different reference structures 26, 26a, each provided with its own detector 28. 28a. By way of example elements for measuring intensity of light only two pairs of orders have been shown, but elements for a greater number of pairs of orders can be realized analogously. Although only two reference structures 26, 26a and corresponding detectors 28, 28a have been shown, for pairs of diffraction orders +-1 and +-2 respectively. It should be understood that in practice a larger number of diffraction orders, for example seven pairs of diffraction orders +-n (n=1,2,3,4,5,6,7..) may be treated separately, each with its own reference structure and detector.

Processing unit 29 uses the electric signal from detector 28 to generate control signals for positioning means PW. Processing unit 29 measures the position of substrate W and the alignment system relative to one another, i.e. it determines for which output value of Interferometric measuring means IF substrate W and alignment subsystem are in a specific alignment relative to one another. Subsequently, processing unit 29 uses this measurement to control one or more positions with a predetermined offset to a position at which substrate W and the alignment subsystem are in alignment, to which substrate is moved for illumination with projection beam PB.

Although single elements 240, 242 have been shown for the sake of simplicity, it should be understood that in practice the imaging structure 24 may comprise a combination of lenses or imaging mirrors.

Furthermore, although a configuration has been shown wherein radiation is first reflected from substrate W and then transmitted through reference structure 26 before detection, it should be appreciated that other configurations may be used. For example, radiation reflected off reference structure 26 may be detected and/or radiation transmitted through substrate W may be used if substrate W permits this. Similarly, radiation may be fed to reference structure 26 first (for reflection or transmission) before being fed to substrate W prior to detection. Also, of course, the invention is not limited to the perpendicular incidence shown in figure 2.

When substrate W is displaced relative to the alignment subsystem in a direction along which optical properties of alignment structure 22 vary periodically, the relative phase of the reference structures 26, 26a and the periods in the imaged of alignment structure 22 varies proportionally to the displacement. As a result the spatially averaged intensity of light passed by reference structures 26, 26a also varies periodically, dependent on the extent to which blocking parts of the periods of reference structures 26, 26a block the higher intensity parts of the periods of the image of alignment structure 22.

Processing unit 29 determines the amplitude and phase of these periodic variations. The phase is a periodic function of displacement: each time when substrate W has been displaced by a complete period of alignment structure 22 the measured phase values repeat. This means that the position can in principle be determined from the phase, except for an ambiguity of an integer number of periods.

Unfortunately, the relation between displacement and measured phase may depend on the way substrate W has been subjected to processing steps. When the processing steps affect the phase measurements accurate alignment is jeopardized. For different instances of the same alignment mark may differ, both dependent on the order and dependent on the alignment mark. This is an effect of the processing to which the substrate has been subjected.

Figure 3 shows an example of a cross section of a height profile of an alignment structure 22. An underlying profiled layer 40 is shown with a resist layer 42 spun onto the profiled layer. Resist layer 42 is effectively transparent at the operating wavelength of the alignment subsystem, so that it merely affects the phase of diffracted light. Profile contains a ridges 46 which are repeated a number of times with a basic period L. Ideally resist layer 42 would have the same height everywhere, with the result that the mirror symmetry of profiled layer 40 around line 44 would make the entire structure symmetric.

In the case of a symmetric alignment structure 22 on the substrate the position of alignment structure 22 can be determined without detailed knowledge of the optical properties. In this symmetric case symmetry line 44 leads to a symmetry in the periodic variation when the substrate W is displaced relative to the alignment system. This position corresponds to alignment of the symmetry line 44 of alignment structure 22 with a position defined by reference structures 26, 26a. Thus, in case of a symmetric structure accurate alignment can be realized without more detailed knowledge of the optical properties of alignment structure 22.

However, due to spinning or polishing effects the thickness of resist layer 42 on different sides of line 44 differs. By way of example an unevenness 48 (exaggerated amplitude) on one side of ridges 46 is shown. Polishing of the substrate also has been found to lead to thickness variations on one side of a ridge 46 in some cases. This leads to breaking of the symmetry of alignment structure 22 around symmetry line 44. The asymmetry leads to a shift in the phase of the intensity information determined by processing unit 29. In this case knowledge about the details of the alignment structure is needed to realize accurate alignment. Dependent on the details different corrections should be applied to the alignment positions determined from phase measurements. It will be appreciated that this holds not only for spinning or polishing effects but also for any other process effects that affect the symmetry of alignment structure 22.

Processing unit 29 identifies the required correction of for the position determined from the phase of any one pair of orders or combination of pairs of orders of diffracted light, using a set of measurements of the amplitude of the intensities variations for a plurality of different pairs of orders of diffracted light. The underlying justification for this approach is that there is a correlation between the corrections and the amplitudes, because as a result of processing of the substrate only specific corrections can occur in combination with given set of amplitudes. The dependence of the corrections on the intensities is determined either theoretically, using a model for different possible detailed alignment structures that can result from processing of the substrate, followed by a calculation of the phase corrections and the amplitudes consistent with Maxwell's equations (or any suitable optical approximation of these equations) to determine which phase corrections occur in combination with a given combination of intensities. Alternatively, the corrections may be determined experimentally by observing possible combinations of intensities and phase corrections for a training set of alignment structures with positions that have been determined separately.

Figure 4 shows a flow chart for aligning substrate W. In a first step 51 processing unit 29 determines the phase values fₙ of respective pairs of orders of diffraction with order +-n, from the periodic variations of the intensity of light passed by reference structures 26, 26a for the respective ones of the pairs of orders of diffraction. As is known from the prior art, the phase values are related to offset values xₙ of alignment structure 22 according to fₙ = 2pnxₙ /d (d being the period size of the alignment structure). In a second step 52 processing unit 29 determines amplitudes Iₙ of the different orders of diffraction, from the amplitudes of variations of the output of detectors 28a-g when substrate W is moved relative to the alignment system.

In a third step 53 processing unit 29 uses the set of amplitudes Iₙ from second step 52 to determine a set of corrections ?xₙ that should be applied to the positions xₙ determined by the phase values fₙ from first step 51. Third step 53 can be implemented in a number of ways. In one embodiment a parametrized model of the optical properties of alignment structure 22 is used with variable parameters P, together with a first algorithm for computing a predictions of the intensities Iₙ(P) as a function of the parameters P. In this embodiment processing unit 29 searches for a set of parameter values P of the model that minimizes a difference between the measured intensities Iₙ and the predictions Iₙ(P). The search may be conducted for example using a simulated annealing algorithm. Subsequently processing unit 29 uses a second algorithm to compute the corrections ? xₙ(P) for the parameters that have been found according to a second parametrized model.

In a fourth step 54 the corrections ?xₙ that have been determined in third step 53 are applied to the positions xₙ determined in first step 51. Thus, a consistent set of position measurements is obtained, from which an overall alignment position X may be determined for example by averaging the positions xₙ over the different orders of diffraction. In a fifth step 55 substrate W is illuminated with beam PB at one or more positions after positioning substrate table WT and patterning means M relative to one another so that the pattern is projected at a specified position relative to the position of the alignment structure 22 as determined from the calculated overall alignment position X.

It should be appreciated that various modifications may be applied to the alignment process described by means of figure 4. For example, instead of computing and applying corrections for individual orders, one may also compute a position from a combination of uncorrected measurements for different orders, followed by correction of the combined result. As another example, in addition to the amplitude measurements other measured properties of the substrate, such as the variation of the phase values over the different orders may be used to determine the required corrections. Thus, for example, the model parameters may be fit so as to minimize the difference between predictions and measurements of both phase values and amplitude values. Intensity measurements made with light of the same or with light of other wavelengths than the phase measurements may be used to determine the corrections, alone or in combination with intensity measurements made at the other and the same wavelengths. In general, use of amplitudes from more pairs orders of diffraction will increase accuracy.

Also one may use intensity measurement of light diffracted in diffraction orders from one or more other reference structures than the reference structure for which the corrections are determined, to determine the corrections. These other reference structures may be on the same substrate or even on different substrate that have been subjected to processing as a batch together with the substrate that contains the reference structure for which the corrections are determined. However preferably processing unit 29 uses at least the amplitude measurements made concurrently with the determination of the phase values, i.e. with the same light at the same wavelength. Thus hardly any measuring overhead is required for the correction.

Furthermore, instead of fitting parameter values P in third step 53, the amplitude values and whatever other measurements are used to determine the corrections may be used as an index to retrieve stored information about correction values. This may be realized for example by generating the corrections as a parametrized function of the amplitudes, the parameters of the function being trained by means computations of corresponding intensities and corrections as described in the preceding. As a special type of function a neural network function may be used, after similar training a neural network.

Such a neural network may be trained, or the parameters of the parametrized function may be estimated, for example by measuring the amplitudes for a test substrate, positioning and illuminating the test substrate W at some position relative to the mask M, and subsequently processing the test substrate so that the relative position of first features determined by the mask and second features of the underlying substrate become detectable. As a first feature a first rectangle may be used that contains a second rectangle that is used as second feature. By measuring the relative position of the first and second features a set of training data is obtained that describes the corrections for the set of measured amplitudes. Alternatively or in addition, a theoretical model may be used, and the training data consistent with this model may be generated. The set of training data may be used to train the neural network in a known neural network training algorithm.

Good results have been obtained for example with a neural network that uses input signals that encode the amplitude of seven pairs of orders of diffraction for two colors (14 signals) and the phase of these pairs of orders (another 14 signals). In this example weighted sums of these input signals are applied to six neurons with for example S shaped response functions. A weighted sum of the outputs of these neurons is fed to an output neuron with a linear response function, which represents the estimated position. The weight values used in the weighted sums are determined by neural network training by means of examples. Thus significantly improved positioning was achieved. In addition to the single output neuron for position, more output neurons may be used to estimate other parameters such as shape parameters of the alignment marks.

Alternatively, parameters of the parametrized function may be estimated (e.g. coefficients of a linear or polynomial function), for example using an estimate that minimizes a least squares difference between the predicted and measured corrections for a plurality of training sets.

Similarly, training data may be obtained from other measurements of the actual correction, performed e.g. by removing part of the photosensitive layer and measuring the correction between measurements made where the layer is present and layer has been removed.

Similarly, this type of training data may be obtained for training the computation of the offset if other measurements than the amplitudes are used.

In principle, the corrections may be computed anew for every alignment structure 22. Since the corrections are determined by processing steps to which an entire substrate W is subjected, or even a batch of such substrates, the corrections needed for different alignment structures on the same substrate or on different substrates may be correlated as well. Accordingly intensity measurements for one or more different reference structures on the substrate or on other substrates from the same batch may be used to initialise or constrain the search for parameter values P that best fit the intensity measurements. Thus, less searching is required.

Advantageously processing unit 29 is programmed with a physical model, which relates shape parameters of alignment mark 22 to measured parameters such as the phase and amplitude of the periodic variations of the intensity at detectors 28, 28a consistent with Maxwell's equations. Such physical models are known per se. For example, such a physical model may use a complex reflection coefficient function Gₖ(r) as a function of coordinates r=(x,y) of position in an arbitrary virtual plane at substrate W (k being the wave-vector of the incoming light). Gₖ(x,y) determines the refracted amplitude and phase exp(jk.r)*Gₖ(x,y) of the light at position x, y in said plane in response to an incident field exp(jk.r). When Gₖ(x,y) is known well known straightforward mathematical relation exists for computing the measured parameters at detectors 28, 28a from Gₖ(x,y). Given the shape parameters of alignment mark 22 and the optical properties of its material in turn, Gₖ(x,y) can readily be computed.

In the example of figure 3 for example, this requires parameters characterizing the size and height of ridges 46, the reflectivity of the material of profiled layer 40, the transmission coefficient of resist 42 and an amplitude and/or scale parameter characterizing the unevenness 48 due to spinning or polishing. Processing unit 29 is programmed to compute Gₖ(x,y) from values of these parameters and to compute the amplitude and phase of the intensity variations at detectors 28, 28a from Gₖ(x,y) given the properties of light source 20. For the computation of Gₖ(x,y) known techniques, such as the RCWA technique may used, but often a simple model may suffice, such as the vertical propagation model, which computes Gₖ(x,y) from the reflection coefficient of profiled layer 40 at given points of on the layer and at a given angle of incidence from the properties of the material of that layer and its local orientation, with a phase correction to account for propagation through the overlying layer. By means of inverse modeling values of the parameters may be estimated that fit the measured amplitudes to the computed amplitudes. Processing unit 29 computes the computed parameters corrections of position measurements obtained from the phase values.

It will be appreciated that this technique it not limited to the phase grating alignment sensor shown in figure 2. It may also be applied to other sensors, e.g. a correlation sensor that forms an image of a non-periodic alignment structure and computes a correlation coefficient between this image with a reference image, estimating the position of the substrate from the location of the maximum of the correlation coefficient, or to a sensor that detects edges between features in an image of the (not necessarily periodic) alignment structure and measures the position of these edges to estimate the position of the alignment structure or to any other optical sensor. In each case a model can be programmed that relates shape parameters of the alignment structure to measured quantities such as correlation as a function of position, image edge profile etc., from which the parameters can be estimated and used to correct the measured position.

By supplying a model expressed in terms of parameters of the substrate that are adjustable during alignment (as far as relevant for the optical properties of the alignment structure) and computing the optical relation between those parameters and quantities measured by the alignment system during alignment, one obviates the need to provide extensive position measurements to calibrate the position corrections. The model may be expressed in any terms. Preferably, shape parameters are used, which parametrize the geometrical form of structures on the substrate such as ridges. Examples of such parameters are parameters describing edge slope of ridges on either side of the ridges, slopes of the platform at the top of the ridges and the valleys between the ridges, edge height or depth, layer thickness of a layer on top op ridges etc. In addition other parameters may be given for which fixed values are set a priori before alignment.

Alternatively, or in addition, non-geometrical parameters may be used, such as the refractive index of the material in layers on the substrate, or the reflection coefficient of material used for the structures. These parameters can usually be set a priori. As yet another alternative optical parameters may be used such as coefficients that describe a piecewise approximation of Gₖ(x,y) at or near the surface of the alignment structure in a direction along which the alignment structure varies periodically (e.g. in terms of a polynomial approximation). The pieces of the piecewise approximation in this case correspond approximately to successive structures on the substrate in the alignment structure. Such parameters are equivalent to more structural parameters as far as the optical effects are concerned. Of course, in case of such parameters also some of the parameters may be fixed a priori and for others values are determined during alignment.

Preferably processing unit 29 is programmed to be able to perform this type of computation using any combination of a programmed set of parameters. In a further embodiment processing unit 29 is provided with an interface for commanding processing unit 29 to select which of the set of available parameters should be used. The interface is for example a keyboard for entering a selection of the parameters, or a network connection (not shown) along which a Computer Aided Manufacturing system signals a selection of these parameters to processing unit 29. Thus technologists, who know the processes used to process the substrate and the values of parameters that are likely to result from these processes as well as the parameters that are likely to be variable, are able to adapt operation of the alignment system without knowledge of optical properties of the alignment subsystem.

The parameters for which values may be selected during alignment need not be selected explicitly each time. Instead, processing unit 29 may contain stored subset selections, so that the interface need only specify one of the stored subsets. In addition the interface may be used to specify values for the unselected parameters and ranges or mean values for the selected parameters.

Using the information from the interface processing unit 29 adapts the computation of the parameters as selected, and corrects the position measurements according to the parameters that have thus been computed. In this way the user can modify the operation of processing unit dependent on the type of processing to which substrate W has been subjected prior to alignment.

Whilst specific embodiments of the invention have been described above, it will be appreciated that the invention may be practiced otherwise than as described. The description is not intended to limit the invention.

## Claims

1. A lithographic projection apparatus comprising:
- a support structure for supporting patterning means, the patterning means serving to pattern a projection beam according to a desired pattern;
- a substrate table for holding a substrate that comprises an alignment structure with spatially periodically varying optical properties; and
- an optical alignment system, arranged to
- use positional information from light affected by the substrate to determine a position of said alignment structure relative to the patterning means; and
- control a relative positioning of the patterning means and the substrate dependent on the position,
**characterized in that** the optical alignment system is arranged to
- measure position invariant information of the light affected by the substrate or light affected by a further substrate that has been subjected to one or more processing steps in common with said substrate or with the same value of processing parameters used for processing said substrate; and
- to determine, under control of at least the position invariant information, a size of a correction to be used for determining said position from the phase value.

2. A lithographic projection apparatus according to Claim 1, wherein the optical alignment system is a phase grating alignment system, arranged to
- measure a phase value of intensity variations of a pair of orders of light diffracted by the alignment structure as a function of relative position of the substrate;
- determine the position of said alignment structure relative to the patterning means from the phase value; and
- control a relative positioning of the patterning means and the substrate dependent on the position,
**characterized in that** the phase grating alignment system is arranged to
- measure amplitudes of relative position dependent intensity variations of individual ones of a plurality of different pairs of orders of diffracted light from the alignment structure or a further alignment structure with spatially periodic optical properties on said substrate or on a further substrate that has been subjected to one or more processing steps in common with said substrate or with the same value of processing parameters used for processing said substrate; and
- to determine, under control of at least the measured intensity values, a size of a correction to be used for determining said position from the phase value.

3. A lithographic projection apparatus according to Claim 1 or 2, wherein the alignment system is arranged to measure respective position invariant information for light of a plurality of wavelengths and to use a combination respective position invariant information measured for the plurality of wavelengths to determine said correction.

4. A lithographic projection apparatus according to any one of the preceding claims, comprising a neural network implementation taught to determine the correction under control of at least the position invariant information.

5. A lithographic projection apparatus according to any one of the preceding claims, wherein the alignment system comprises information representing a parametrized model descriptive of position dependent reflection or transmission of the alignment structure, the alignment system being arranged to
- estimate a value or values of one or more parameters of the model that correspond to the amplitudes according to the physical laws of optics;
- determine the correction dependent on the estimated value or values.

6. A lithographic projection apparatus according to Claim 5, wherein the alignment system is arranged to compute information about a difference between the measured values of the amplitudes and model based values of the amplitudes according to the parametrized model and the physical laws of optics and to determine the estimated value or values so as to minimize the difference.

7. A lithographic projection apparatus according to Claim 2, wherein the alignment system is arranged to measure the phase value for a plurality of different pairs of orders of diffraction, the correction being identified dependent on a combination of the phase value for the plurality of different pairs of orders of diffraction and the amplitude values.

8. A lithographic projection apparatus according to Claim 7, wherein the alignment system comprises information representing a parametrized model descriptive of position dependent reflection or transmission of the alignment structure, the alignment system being arranged to
- compute information about a difference between the measured values of the amplitudes and model based values of the amplitudes according to the parametrized model and the physical laws of optics
- estimate a value or values of the position in combination with one or more parameters of the model that minimize the difference.

9. A lithographic projection apparatus according to Claim 5, 6 or 8, wherein the alignment system is arranged to provide for a set of available parameters of the model, and comprises an interface for selecting the parameter or parameters for which values are estimated to determine the correction from the set of available parameters of the model, the alignment estimating the value or values of only the selected parameter or parameters for determining the correction.

10. A lithographic projection apparatus according to any one of Claims 5, 6, 8 or 9, wherein the one or more parameters of the model describe geometrical properties of the alignment structure.

11. A lithographic projection apparatus comprising:
- a support structure for supporting patterning means, the patterning means serving to pattern a projection beam according to a desired pattern;
- a substrate table for holding a substrate with an alignment structure;
- an alignment system, arranged to
- measure properties of light reflected or transmitted by the alignment structure;
- determine a position of said alignment structure relative to the patterning means from the optical properties; and
- control a relative positioning of the patterning means and the substrate dependent on the position,
**characterized in that** the alignment system contains information representing a parametrized model descriptive of physical properties of the alignment structure, the alignment system being arranged to
- estimate a value or values of one or more parameters of the model that according to the physical laws of optics substantially result in the measured properties measured by the alignment structure;
- determine the position that corresponds to the measured properties subject to the estimated value or values.

12. A lithographic projection apparatus according to Claim 11, wherein the alignment system is arranged to compute information about a difference between the measured values of the properties and modeled values of the properties corresponding to the parametrized model and the physical laws of optics and to determine the estimated value or values so as to minimize the difference.

13. A lithographic projection apparatus according to Claim 11 or 12, wherein the alignment system has an interface for selecting the parameter or parameters for which values are estimated to determine the correction from a set of available parameters of the model, the alignment system estimating a value or values only for the selected parameters.

14. A lithographic projection apparatus according to any one of Claims 11 to 13, wherein the one or more parameters of the model describe geometrical properties of the alignment structure.

15. A device manufacturing method comprising the steps of:
- providing patterning means to endow a projection beam with a pattern in its cross-section;
- providing a substrate that is at least partially covered by a layer of radiation-sensitive material, the substrate comprising an alignment structure with spatially periodically variable optical properties;
- using positional information from light affected by the substrate to determine a position of said alignment structure relative to the patterning means; and
- controlling a relative positioning of the patterning means and the substrate dependent on the position;
**characterized in that** said determining of the position comprises
- measuring position invariant information in the light affected by the substrate or light affected by a further substrate that has been subjected to one or more processing steps in common with said substrate or with the same value of processing parameters used for processing said substrate; and
- determining, under control of at least the position invariant information, a size of a correction to be used for determining said position from the phase value.

16. A device manufacturing method according to Claim 15, wherein said using of positional information comprises
- measuring a phase value of intensity variations of a pair of orders of light diffracted by the a phase grating alignment structure as a function of relative position of the substrate;
- determining the position of said alignment structure relative to the patterning means from the phase value;
**characterized in that** the measuring of position invariant information comprises
- measuring amplitudes of relative position dependent intensity variations of individual ones of a plurality of different pairs of orders of diffracted light from the alignment structure or a further alignment structure with spatially periodic optical properties on said substrate or on a further substrate that has been subjected to one or more processing steps in common with said substrate or with the same value of processing parameters used for processing said substrate; and
- determining, under control of at least the measured intensity values, a correction to be used for determining said position from the phase value.

17. A device manufacturing method according to Claim 15 or 16, wherein measuring of position invariant informationincludes measuring respective position invariant information for light of a plurality of wavelengths and using a combination of respective position invariant information measured for the plurality of wavelengths to determine said correction.

18. A device manufacturing method according to Claim 15 or 16, comprising using a neural network implementation to determine the correction under control of at least the position invariant information and teaching the neural network implementation to determine the correction by means of training examples that contain measurements of required corrections and corresponding measurements of position invariant information and/or theoretically predicted examples of combinations of corrections and position invariant information.

19. A device manufacturing method according to any one of Claims 15 to 17, comprising
- providing a parametrized model descriptive of position dependent reflection or transmission of the alignment structure;
- estimating a value or values of one or more parameters of the model that correspond to the amplitudes according to the physical laws of optics;
- determining the correction dependent on the estimated value or values.

20. A device manufacturing method according to Claim 19, comprising computing information about a difference between the measured values of the amplitudes and model based values of the amplitudes according to the parametrized model and the physical laws of optics and determining the estimated value or values so as to minimize the difference.

21. A device manufacturing method according to Claim 15, comprising measuring said phase value for a plurality of different pairs of orders of diffraction, the correction being identified dependent on a combination of the phase value for the plurality of different pairs of orders of diffraction and the amplitude values.

22. A device manufacturing method according to Claim 21, comprising
- providing a parametrized model descriptive of position dependent reflection or transmission of the alignment structure;
- computing information about a combined difference between the measured values of the amplitudes and measured phase values on one hand and model based values of the amplitudes and phase according to the parametrized model and the physical laws of optics on the other hand;
- estimating a value or values of the position in combination with one or more parameters of the model that minimize the difference.

23. A device manufacturing method according to Claim 19,20 or 22, comprising selecting the parameter or parameters for which values are estimated to determine the correction from a set of available parameters of the model, said selecting dependent on the nature of the processing steps to which the substrate has been subjected.

24. A device manufacturing method according to any one of Claims 15 to 23, wherein the one or more parameters of the model describe geometrical properties of the alignment structure.

25. A device manufacturing method comprising the steps of:
using patterning means to endow a projection beam with a pattern in its cross-section;
- providing a substrate that is at least partially covered by a layer of radiation-sensitive material, the substrate comprising an alignment structure;
- measuring properties of light reflected or transmitted by the alignment structure;
- computing a position of the alignment structure from the measured properties;
- controlling a relative positioning of the patterning means and the substrate dependent on the position;
**characterized in that** said computing the position comprises
- providing a parametrized model, descriptive of physical properties of the alignment structure;
- estimating a value or values of one or more parameters of the model that substantially result in the measured properties according to the physical laws of optics;
- determining the position that corresponds to the measured properties subject to the estimated value or values.

26. A device manufacturing method according to Claim 25, comprising computing information about a difference between the measured values of the properties and modeled values of the properties corresponding to the parametrized model and the physical laws of optics and to determine the estimated value or values so as to minimize the difference.

27. A device manufacturing method according to Claim 25 or 26, comprising selecting the parameter or parameters for which values are estimated to determine the correction from a set of available parameters of the model, dependent on the nature of the processing steps to which the substrate has been subjected.

28. A device manufacturing method according to any one of Claims 25 to 27, wherein the one or more parameters of the model describe geometrical properties of the alignment structure.

29. A device manufacturing method according to Claim 25, 26, 27 or 28, comprising using the estimated parameter or parameters to select an initial value in a search for a further parameter or further parameters that substantially result in the measured properties of a further alignment mark on said substrate or on a further substrate that has been subject to a processing step in common with said substrate.
